# EUROPÄISCHE PATENTSCHRIFT

(11) **EP 1 425 799 B1**
(45) Veröffentlichungstag und Bekanntmachung des Hinweises auf die Patenterteilung: **20.07.2005**
(21) Anmeldenummer: 02758032.3
(22) Anmeldetag: 09.09.2002
(51) Int. Cl.: H01L 23/48

(54) **DRUCKKONTAKTIERBARES LEISTUNGSHALBLEITERMODUL**
PRESSURE-CONTACTABLE POWER SEMICONDUCTOR MODULE
MODULE SEMI-CONDUCTEUR DE PUISSANCE MIS EN CONTACT PAR PRESSION

(30) Priorität: 10.09.2001 EP 01810870
(43) Veröffentlichungstag der Anmeldung: 09.06.2004
(73) Patentinhaber: ABB Schweiz AG, 5400 Baden (CH)
(72) Erfinder: SCHNEIDER, Daniel, CH-8001 Zürich (CH); TRÜSSEL, Dominik, CH-5620 Bremgarten (CH)
(74) Vertreter: ABB Patent Attorneys
(86) Internationale Anmeldenummer: PCT/CH2002/000492
(87) Internationale Veröffentlichungsnummer: WO 2003/023854

(56) Entgegenhaltungen:
- EP-A- 0 428 044
- DE-A- 19 903 245
- GB-A- 1 120 039
- US-A- 3 450 962
- US-A- 3 566 209
- US-A- 4 882 612

## Beschreibung

### Technisches Gebiet

Die Erfindung bezieht sich auf das Gebiet der Leistungselektronik. Sie betrifft ein druckkontaktierbares Leistungshalbleitermodul nach dem Oberbegriff des ersten Anspruchs.

### Stand der Technik

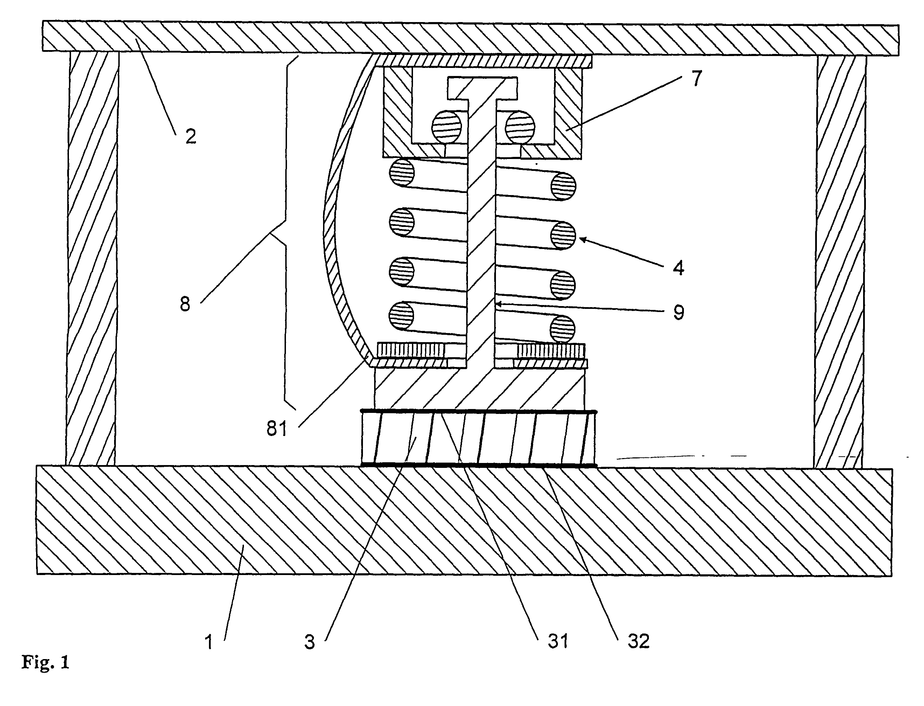

Ein solches Leistungshalbleitermodul wird bereits in der Offenlegungsschrift DE 199 03 245 A1 beschrieben. Es handelt sich dabei um ein Leistungshalbleitermodul vom sogenannten Druckkontakt-Typ mit mindestens einem Halbleiterbauelement, wie in Fig. 1 gezeigt. Ein erster Hauptanschluss 31 des Halbleiterbauelements 3 wird durch mindestens ein Kontaktelement 8 elektrisch leitend mit einer Deckplatte 2 verbunden. Mit einem zweiten Hauptanschluss 32 ist das Halbleiterbauelement 3 auf einer Basisplatte 1 angeordnet.

Für eine zuverlässige Kontaktierung in derartigen Leistungshalbleitermodulen werden Drücke in der Grössenordnung von 1kN/cm² benötigt. Zur Erzeugung dieser Drücke bei gleichzeitiger Kompensation von Schwankungen der Dicke der Halbleiterbauelemente, insbesondere bei Modulen mit mehreren Halbleiterbauelementen, weist das Kontaktelement 8 mindestens ein Federelement 4 auf, welches im Allgemeinen als Spiralfeder oder als Stapel von Tellerfedern ausgeführt ist.

Eine Schwierigkeit besteht darin, im Kontaktelement das Federelement mit einer geeigneten Stromführung zu kombinieren. In DE 199 03 245 A1 wird dies dadurch gelöst, dass die Stromführung mittels einem flexiblen Verbindungsbügel oder -draht 81 um das Federelement herumgeführt wird. Aus diesem Grund muss der Verbindungsbügel 81 eine Mindestlänge aufweisen, die durch die Abmessungen des Federelements gegeben ist. Darüber hinaus ist der maximale Querschnitt eines derartigen Verbindungsbügels 81 begrenzt, da ansonsten seine Beweglichkeit eingeschränkt würde. Aus den beiden ebengenannten Anforderungen resultiert bei vorgegebenen Abmessungen des Federelements eine untere Grenze für den thermischen und elektrischen Widerstand des Verbindungsbügels, die nicht unterschritten werden kann. Aus diesem Grund muss bei Auswahl bzw. Gestaltung des Federelements darauf geachtet werden, dass Abmessungen erreicht werden, die tolerierbare Widerstandswerte des Verbindungsbügels 81 ermöglichen.

Um das Leistungshalbleitermodul selbst oder auch ein eventuell übergeordnetes System bei einem Ausfall eines oder mehrerer Halbleiterbauelemente 3 voll funktionsfähig zu erhalten, ist es in vielen Fällen erforderlich, dass ein defektes Halbleiterbauelement 3 in einen stabilen Kurzschlussmodus ("short-circuit failure mode", SCFM) übergeht, in welchem zwischen erstem und zweitem Hauptanschluss ein dauerhafter, elektrisch leitender Kontakt mit möglichst geringem Widerstand und möglichst grosser Stromkapazität besteht. Tritt nun der SCFM bei einem Halbleiterbauelement in einem Druckkontakt-Leistungshalbleitermodul auf, fliesst ein Strom durch das Modul vollständig durch das entsprechende Halbleiterbauelement 3 und den Verbindungsbügel 81 des zugehörigen Kontaktelements 8. Übliche Ströme liegen dabei im Bereich einiger Kiloampere. Aufgrund des oben erwähnten thermischen Widerstands des Verbindungsbügels 81 können somit im Halbleiterbauelement 3 Temperaturen von weit über 200°C auftreten. Bauelementseitig wird dadurch der Verbindungsbügel 81 auf ähnlich hohe Temperaturen erwärmt, was zu einer starken Beanspruchung führt.

Das Kontaktelement in DE 199 03 245 A1 weist zudem einen internen Druckkontakt zwischen dem Verbindungsbügel 81 und einem Druckstempel 9 auf. Dadurch wird die Gesamtzahl der Druckkontakte im Leistungshalbleitermodul erhöht, wodurch elektrische und thermische Gesamtwiderstände erhöht werden.

Beinhaltet ein Leistungshalbleitermodul mehr als ein Kontaktelement 8, muss bei einer Bestückung darauf geachtet werden, dass die Verbindungsbügel 81 sich gegenseitig nicht berühren. Aus diesem Grund müssen bei Herstellung entsprechend grosse Abstände zwischen den Kontaktelementen 8 vorgesehen werden und/oder bei der Bestückung auf eine korrekte gegenseitige Ausrichtung der Kontaktelemente 8 geachtet werden.

Das Dokument EP 0 428 044 A offenbart ein druckkontaktierbares Halbleiterbauelement, bei dem eine elektrisch leitende Verbindung in Form eines Kontaktstempels von einer Hauptelektrode des Bauelements durch ein Federelement geführt ist.

### Darstellung der Erfindung

Der vorliegenden Erfindung liegt die Aufgabe zugrunde, ein Leistungshalbleitermodul der eingangs genannten Art anzugeben, welches ohne einen zum Zwecke einer Stromführung um ein Federelement eines Kontaktelements herumgeführten Verbindungsbügel auskommt. Der Erfindung liegt ferner die Aufgabe zugrunde, bestehende Beschränkungen bei Auswahl und Gestaltung eines Federelements hinsichtlich dessen Abmessungen aufzuheben. Der Erfindung liegt weiter die Aufgabe zugrunde, eine Anzahl der notwendigen Druckkontakte im Leistungshalbleitermodul zu minimieren. Schliesslich liegt der Erfindung die Aufgabe zugrunde, eine kompaktere Bauweise der Leistungshalbleitermodule zu ermöglichen und eine Bestückung zu vereinfachen.

Diese Aufgabe wird durch ein Leistungshalbleitermodul gemäss Anspruch 1 gelöst. Erfindungsgemäss wird eine Kombination aus Stromführung und Federelement dergestalt geändert, dass eine elektrisch leitende Verbindung zwischen einem ersten Hauptanschluss eines Halbleiterbauelements und einer Deckplatte durch einen Innenbereich des Federelements geführt wird. Strom und Wärme werden somit nicht mehr aussen um das Federelement herumgeführt, sondern werden innerhalb des Federelements geführt. Auf diese Weise wird sowohl ein minimaler als auch ein durchschnittlicher Querschnitt der leitenden Verbindung im Vergleich zum Stand der Technik vergrössert. Bereiche der Verbindung mit Querschnittswerten nahe dem minimalen Querschnitt werden verkürzt. Ingesamt wird so eine deutliche Reduktion des elektrischen und insbesondere des thermischen Widerstandes erreicht. Unter dem Innenbereich wird im Folgenden eine Aussparung, Öffnung, Durchführung oder ähnliches verstanden, welche das Federelement im wesentlichen parallel zu einer vorgesehen Kompressionsrichtung des Federelements durchsetzt.

Weiterhin können aufgrund der Erfindung grössere Federelemente eingesetzt werden. Darüber hinaus können interne Druckkontakte zwischen Bestandteilen des Kontaktelements eliminiert werden. Der Wegfall des Verbindungsbügels erlaubt eine kompakte Bauweise und eine einfache Bestückung der erfindungsgemässen Leistungshalbleitermodule.

Diese und weitere Aufgaben, Vorteile und Merkmale der Erfindung werden aus der nachfolgenden, detaillierten Beschreibung eines bevorzugten Ausführungsbeispiels der Erfindung in Verbindung mit den Zeichnungen offensichtlich.

### Kurze Beschreibung der Figuren

Es zeigen schematisch:
Fig. 1 ein Leistungshalbleitermodul gemäss dem Stand der Technik,
Fig. 2a einen Schnitt durch ein Teil eines erfindungsgemässen Leistungshalbleitermoduls in einer ersten Ausführungsform ohne Einwirkung einer Druckkontaktkraft,
Fig. 2b das Leistungshalbleitermodul aus Fig. 2a unter Einwirkung einer Druckkontaktkraft,
Fig. 3 einen Schnitt durch ein Teil einer bevorzugten Weiterbildung eines erfindungsgemässen Leistungshalbleitermoduls und
Fig. 4 einen Schnitt durch ein Teil eines erfindungsgemässen Leistungshalbleitermoduls in einer weiteren bevorzugten Ausgestaltung.

Die in der Zeichnung verwendeten Bezugszeichen und deren Bedeutung sind in der Bezugszeichenliste zusammengefasst. Grundsätzlich sind gleiche Teile mit gleichen Bezugszeichen versehen.

### Wege zur Ausführung der Erfindung

Fig. 2a zeigt schematisch einen Schnitt durch einen Teil eines erfindungsgemässen Leistungshalbleitermoduls in einer ersten Ausführungsform ohne Einwirkung einer Druckkontaktkraft. Ein Halbleiterbauelement 3 liegt mit einem zweiten Hauptanschluss 32 auf einer Basisplatte 1 auf. Ein Kontaktstempel 5 liegt mit einer Kontaktfläche auf einem ersten Hauptanschluss 31 des Halbleiterbauelements 3 auf. Ein Stempelhals 52 des Kontaktstempels 5 ragt dabei in einen Innenbereich 44 eines Federelements 4. Bei diesem Ausführungsbeispiel handelt es sich bei dem Federelement 4 um eine Spiralfeder. Der Innenbereich 44 ist in diesem Fall ein im wesentlichen zylindrischer Bereich, der von Windungen der Spiralfeder umschlossen wird. An einer der Deckplatte 2 zugewandten Stirnseite 51 des Kontaktstempels 5 ist ein verformbares Verbindungselement 6 mittels einer festen, stoffschlüssigen Verbindung 56 angebracht und kontaktiert eine Deckplatte 2. Kontaktstempel 5 und Verbindungselement 6 bilden eine Stromführung, deren flexibler Teil örtlich über das Federpaket verlegt ist. Durch eine Querschnittsvergrösserung des Kontaktstempels 5 am der Basisplatte zugewandten Ende des Stempelhalses 52 und eine geeignete Form des Verbindungselements 6 kann das Federelement 4 eine Kraft vom Kontaktstempel 5 auf das Verbindungselement 6 und umgekehrt übertragen. Gegenüber einem im Stand der Technik verwendeten Verbindungsbügel 81 kann das Verbindungselement 6 bei gleichzeitiger Querschnittsvergrösserung verkürzt werden, was zu einer deutlichen Reduktion sowohl des elektrischen wie auch des thermischen Widerstandes führt. Weiter resultiert eine bessere Verteilung des thermischen Widerstandes auf Kontaktstempel 5 und Verbindungselement 6. Bei einem Betrieb des Leistungshalbleitermoduls ergibt sich somit eine homogenes Temperaturgefälle, wobei eine erste Temperatur des Verbindungselements 6 deutlich unter einer zweiten Temperatur des Halbleiterbauelements 3 bleibt. Durch die feste, stoffschlüssige Verbindung 56 zwischen der Stirnseite 51 und dem Verbindungselement 6 entfallen zusätzliche interne Druckkontakte, welche im Kontaktelement nach dem Stand der Technik vorhanden sind. In der gezeigten Ausführungsform kann die Anzahl der Druckkontakte, die sich zwischen der Deckplatte 2 und dem Halbleiterbauelement 3 befinden, auf zwei reduziert werden. Bei der festen, stoffschlüssigen Verbindung 56 handelt es sich vorzugsweise um eine Schweissverbindung, jedoch kann das Verbindungselement 6 auch auf andere Art an der Stirnseite 51 angebracht sein. Ebenfalls vorteilhaft ist beispielsweise eine Lötverbindung oder einer Niedertemperaturverbindung. Es ist jedoch auch von Vorteil, wenn Verbindungselement 6 und Kontaktstempel 5 bereits bei einer Herstellung aus einem Stück direkt gefertigt werden. Auch geschraubte oder genietete Verbindungen können vorteilhaft eingesetzt werden. Kontaktstempel 5 und Verbindungselement 6 sind vorzugsweise rotationssymmetrisch bezüglich einer Drehachse A ausgeführt, jedoch können mit Vorteil auch andere Formen verwendet werden.

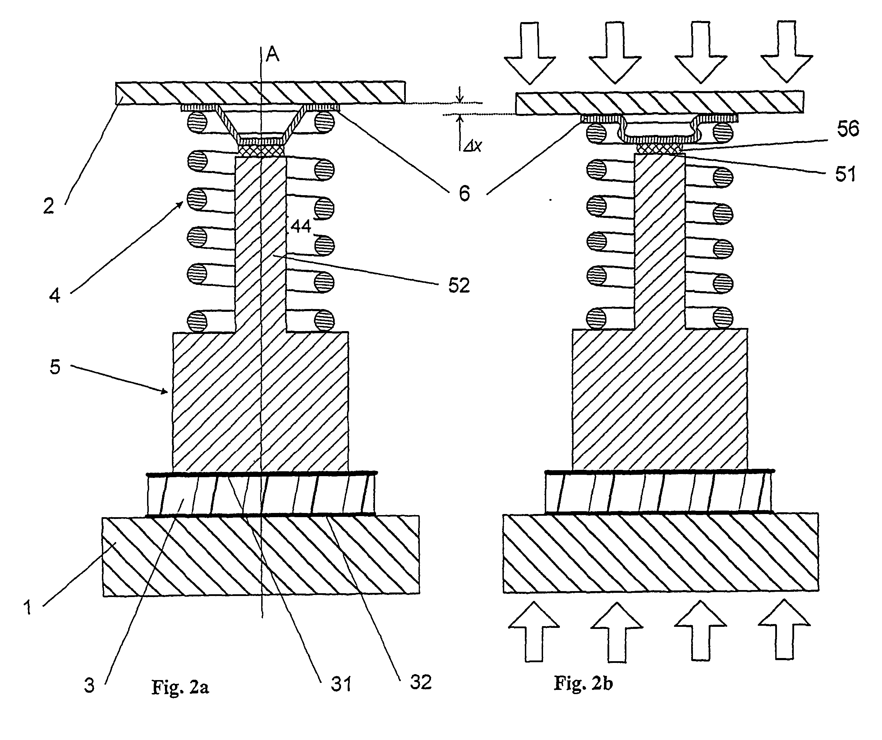

Bei einem Zusammenbau mehrerer Leistungshalbleitermodule zu einem Stapel oder bei einem Einbau eines Leistungshalbleitermoduls in ein übergeordnetes System erfolgt eine elektrische Kontaktierung über die Bodenplatte 1 und die Deckplatte 2, die zu diesem Zweck mit Druck beaufschlagt werden, wodurch das Leistungshalbleitermodul um eine Wegstrecke Δ*x* komprimier wird t, wie in Fig. 2b gezeigt ist. Die Kraft auf Bodenplatte 1 bzw. Deckplatte 2 wird durch das Federelement 4 auf das Verbindungselement 6 bzw. den Kontaktstempel 5 übertragen. Vorzugsweise sind seitliche Modulwände vorhanden (in der Figur nicht gezeigt), die eine maximale Komprimierbarkeit Δ*x*ₘₐₓ des Leistungshalbleitermoduls vorgeben Bei Verwendung einer linearen Feder mit einer Federkonstante *k* ist die Kraft F auf das Verbindungselement 6 und den Kontaktstempel 5 in einem vollständig komprimierten Zustand des Leistungshalbleitermoduls durch *F* = *k* Δ*x*ₘₐₓ gegeben. Vorteilhaft können auch nichtlineare Federn eingesetzt werden.

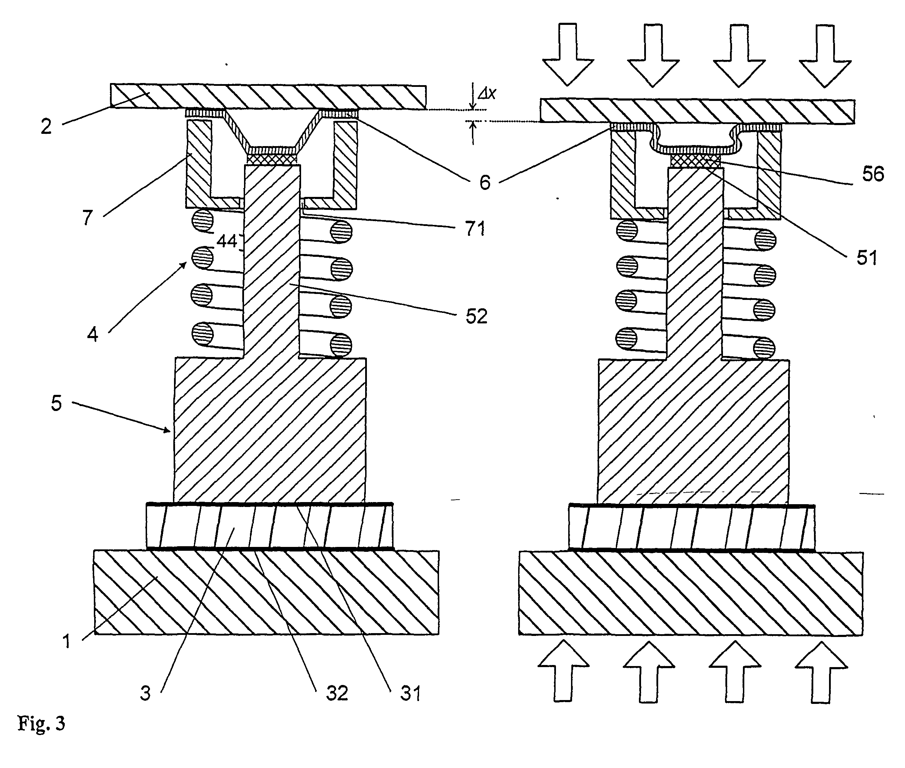

Fig. 3 zeigt schematisch einen Schnitt durch einen Teil einer bevorzugten Weiterbildung eines erfindungsgemässen Leistungshalbleitermoduls. Bei dieser Ausführungsform ist zwischen Federelement 4 und Verbindungselement 6 ein Anpresselement 7 vorhanden. Das Anpresselement 7 weist dabei eine Becherform auf und besteht vorzugsweise aus isolierendem Material. Der Stempelhals 52 des Kontaktstempels 5 ist durch eine Öffnung 71 in einer Bodenwand des Anpresselement 7 geführt. Ein Anpresselement 7 geeigneter Form ermöglicht unabhängig von Art und Form des Federelements 4 eine gleichmässige Verteilung der auf das Verbindungselement 6 übertragenen Kraft. Ausserdem kann das Anpresselement 7 vorteilhaft zu einer Erhöhung des nutzbaren Federwegs eingesetzt werden.

In einer bevorzugten Ausgestaltung der Erfindung ist das Federelement 4 aus einem Stapel von Tellerfedern gebildet, wobei die einzelnen Tellerfedern jeweils mindestens eine Bohrung oder ein Loch aufweisen und so zu einem Federelement zusammengesetzt sind, dass die Bohrungen oder Löcher einen geeigneten Innenbereich zur Durchführung einer elektrisch leitenden Verbindung ergeben. Bei einem derartigen Federelement können Eigenschaften wie z.B. eine Länge im entspannten Zustand oder auch eine Federkennlinie durch Art und/oder Anzahl der im Stapel verwendeten Tellerfedern beeinflusst werden. Dies ermöglicht eine vergrösserte Flexibilität bei einer Herstellung der erfindungsgemässen Leistungshalbleitermodule, weil mit einer geringen Anzahl unterschiedlicher Tellerfedern eine grosse Bandbreite von Leistungshalbleitermodulen mit unterschiedlichem Druckkontakt-Verhalten gefertigt werden kann. Durch die Verwendung eines Stapels von mehreren Tellerfedern werden ferner Abweichungen von einem Sollverhalten des Federelements, die sich aufgrund von Fertigungstoleranzen ergeben, reduziert. Im Vergleich zum Stand der Technik ergibt sich durch Weglassen des äusseren Verbindungsbügels 81 mehr Raum für grössere Tellerfedern. Dies hat zur Folge, dass erstens ein Durchmesser des Innenbereichs stark erhöht werden kann, was einen vergrösserten stromführenden Querschnitt innerhalb der Federn erlaubt, sowie zweitens die grösseren Tellerfedern bei kleinbleibenden inneren Spannungen stärker abgebogen werden können. Somit werden weniger Federn benötigt, um eine gewünschte Federkennlinie zu erreichen.

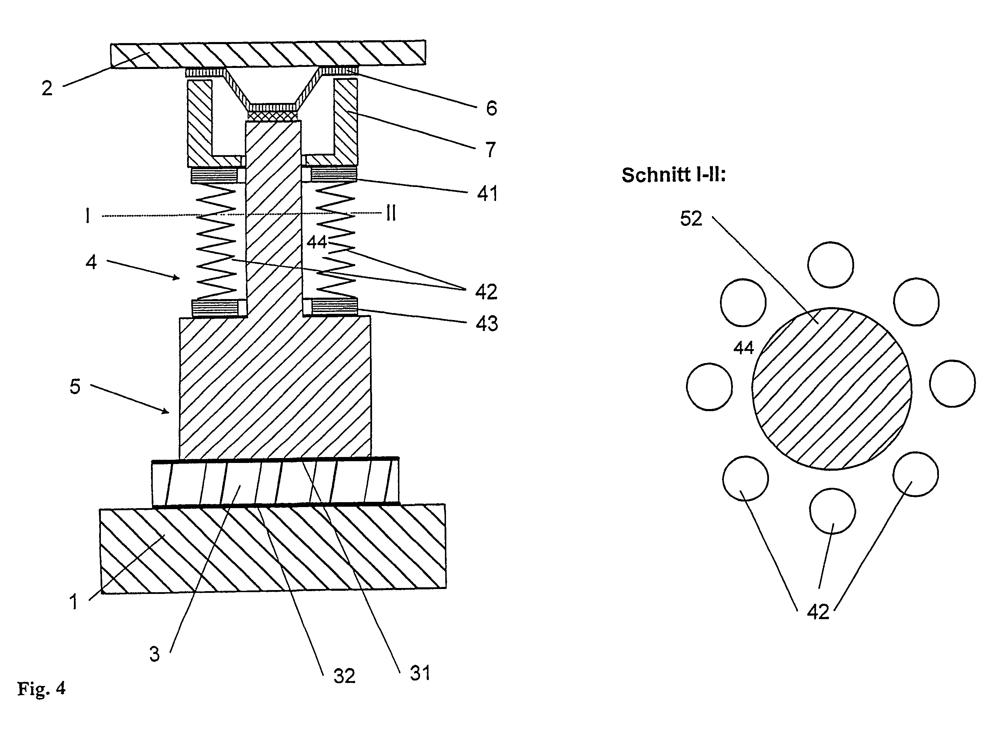

In einer weiteren bevorzugten Ausgestaltung der Erfindung ist das Federelement 4 aus parallel angeordneten Einzelfedern 42 zusammengesetzt, deren erste Enden auf einem ersten Befestigungsring 41 und deren zweite Enden auf einem zweiten Befestigungsring 43 montiert sind, wie in Fig. 4 zu sehen ist. Ein Bereich zwischen den Einzelfedern 42 bildet den Innenbereich 44 dieses Federelements. Auch hier können durch Veränderung von Art und/oder Anzahl der im Federelement 4 verwendeten Einzelfedern 42 Eigenschaften des Federelements 4 beeinflusst werden. Vorteilhaft können anstelle des ersten Befestigungsrings 41 Mittel zur Befestigung der Einzelfedern 42 direkt am Anpresselement 7 vorhanden sein. Ebenso können anstelle des zweiten Befestigungsrings 43 Mittel zur Befestigung der Einzelfedern 42 am Kontaktstempel 5 vorhanden sein.

In einer bevorzugten Ausgestaltung der Erfindung handelt es sich bei dem Halbleiterbauelement 3 um einen einzelnen Halbleiterchip, wobei eine erste und eine zweite Hauptelektrode den ersten bzw. zweiten Hauptanschluss bilden.

In einer weiteren bevorzugten Ausgestaltung der Erfindung handelt es sich bei dem Halbleiterbauelement 3 um ein aus mehreren parallel und/oder in Serie geschalteten Halbleiterchips bestehendes Submodul, bei dem die einzelnen Halbleiterchips auf geeignete Weise untereinander und mit dem ersten und zweiten Hauptanschluss verschaltet sind.

In einer weiteren bevorzugten Ausgestaltung der Erfindung weist das Leistungshalbleitermodul zwischen der ersten Hauptelektrode 31 und dem Kontaktstempel 5 und/oder zwischen der zweiten Hauptelektrode 32 und der Basisplatte 1 Zwischenschichten auf, die als Folie, Platte und/oder Lötschicht ausgeführt sind. Als Beispiel für eine derartige Zwischenschicht seien Platten aufgeführt, welche in ihrer thermischen Ausdehnung an das Halbleiterbauelements 3 angepasst und beispielsweise aus Mo, Cu, oder Mo-Cu-, Al-C-, Cu-C- oder Al-Si-C-Kompositen gefertigt sind.

### Bezugszeichenliste

- 1: Basisplatte
- 2: Deckplatte
- 3: Halbleiterbauelement
- 31: Erster Hauptanschluss
- 32: Zweiter Hauptanschluss
- 4: Federelement
- 41: Erster Befestigungsring
- 42: Einzelfedern
- 43: Zweiter Befestigungsring
- 44: Innenbereich
- 5: Kontaktstempel
- 51: Stirnseite des Kontaktstempels
- 52: Stempelhals
- 56: Feste, stoffschlüssige Verbindung
- 6: Verbindungselement
- 7: Anpresselement
- 71: Öffnung
- 8: Kontaktelement
- 81: Verbindungsbügel oder -draht
- 9: Druckstempel

## Patentansprüche

1. Druckkontaktierbares Leistungshalbleitermodul, umfassend
- eine Basisplatte (1),
- eine Deckplatte (2),
- mindestens ein Halbleiterbaulement (3) mit einem ersten Hauptanschluss (31) und mit einem zweiten Hauptanschluss (32), welcher mit der Basisplatte (1) in elektrisch leitender Verbindung steht,
- mindestens ein Federelement (4), welches zwischen dem ersten Hauptanschluss (31) und der Deckplatte (2) angeordnet ist,
**dadurch gekennzeichnet, dass**
- eine einen Kontaktstempel (5) umfassende elektrisch leitende Verbindung zwischen dem ersten Hauptanschluss (31) und der Deckplatte (2) durch einen Innenbereich des Federelements (4) geführt ist, wobei das Federelement (4) der Kraftübertragung zwischen der Deckplatte (2) und dem Kontaktstempel (5) dient.

2. Leistungshalbleitermodul nach Anspruch 1, **dadurch gekennzeichnet, dass**
- der Kontaktstempel (5) an einer der Deckplatte (2) zugewandten Stirnseite (51) ein verformbares Verbindungselement (6) aufweist, welches mit der Deckplatte (2) in elektrisch leitender Verbindung steht.

3. Leistungshalbleitermodul nach Anspruch 2, **dadurch gekennzeichnet, dass**
- das Verbindungselement (6) mittels einer festen, stoffschlüssigen Verbindung (56) an der Stirnseite (51) des Kontaktstempels (5) angebracht ist.

4. Leistungshalbleitermodul nach Anspruch 2 oder 3, **dadurch gekennzeichnet, dass**
- durch das Federelement (4) eine Kraft zwischen dem Kontaktstempel (5) und dem Verbindungselement (6) übertragbar ist.

5. Leistungshalbleitermodul nach Anspruch 4, **dadurch gekennzeichnet, dass**
- zur Übertragung der Kraft zwischen dem Kontaktstempel (5) und dem Verbindungselement (6) ein Anpresselement (7) zwischen Kontaktstempel (5) und Verbindungselement (6) vorgesehen ist.

6. Leistungshalbleitermodul nach Anspruch 5, **dadurch gekennzeichnet, dass**
- das Anpresselement (7) im wesentlichen becherförmig ausgeführt ist und ein Stempelhals (52) des Kontaktstempels (5) durch eine bodenseitige Öffnung (71) im Anpresselement (7) geführt ist.

7. Leistungshalbleitermodul nach einem der vorangehenden Ansprüche, **dadurch gekennzeichnet, dass**
- das Anpresselement (7) aus elektrisch isolierendem Material besteht

8. Leistungshalbleitermodul nach einem der vorangehenden Ansprüche, **dadurch gekennzeichnet, dass**
- das Federelement (4) aus einem Stapel von Tellerfedern gebildet ist.

9. Leistungshalbleitermodul nach einem der Ansprüche 1 bis 7, **dadurch gekennzeichnet, dass**
- das Federelement (4) mehrere, parallel angeordnete Einzelfedern (42) aufweist.

10. Leistungshalbleitermodul nach einem der Ansprüche 1 bis 9, **dadurch gekennzeichnet, dass**
- sich zwischen der ersten Hauptelektrode (31) und dem Kontaktstempel (5) mindestens eine elektrisch leitende Schicht befindet.

11. Leistungshalbleitermodul nach einem der Ansprüche 1 bis 10, **dadurch gekennzeichnet, dass**
- sich zwischen der zweiten Hauptelektrode (32) und der Basisplatte (1) mindestens eine elektrisch leitende Schicht befindet.

## Claims

1. Power semiconductor module capable of pressure contact, comprising
- a base plate (1),
- a cover plate (2),
- at least one semiconductor device (3) with a first main terminal (31) and with a second main terminal (32), which is in electrically conducting connection with the base plate (1),
- at least one spring element (4), which is arranged between the first main terminal (31) and the cover plate (2),
**characterized in that**
- an electrically conducting connection, comprising a contact stamp (5), between the first main terminal (31) and the cover plate (2) is led through an inner region of the spring element (4), the spring element (4) serving for the force transfer between the cover plate (2) and the contact stamp (5).

2. Power semiconductor module according to Claim 1, **characterized in that**
- the contact stamp (5) has on an end face (51) facing the cover plate (2) a deformable connecting element (6), which is in electrically conducting connection with the cover plate (2).

3. Power semiconductor module according to Claim 2, **characterized in that**
- the connecting element (6) is attached on the end face (51) of the contact stamp (5) by means of a fixed, integral connection (56).

4. Power semiconductor module according to Claim 2 or 3, **characterized in that**
- a force can be transferred between the contact stamp (5) and the connecting element (6) by the spring element (4).

5. Power semiconductor module according to Claim 4, **characterized in that**
- for transferring the force between the contact stamp (5) and the connecting element (6), a pressure-exerting element (7) is provided between the contact stamp (5) and the connecting element (6).

6. Power semiconductor module according to Claim 5, **characterized in that**
- the pressure-exerting element (7) is formed substantially as a cup and a stamp neck (52) of the contact stamp (5) is led through an opening (71) in the bottom of the pressure-exerting element (7).

7. Power semiconductor module according to one of the preceding claims, **characterized in that**
- the pressure-exerting element (7) consists of electrically insulating material.

8. Power semiconductor module according to one of the preceding claims, **characterized in that**
- the spring element (4) is formed by a stack of cup springs.

9. Power semiconductor module according to one of Claims 1 to 7, **characterized in that**
- the spring element (4) has a number of individual springs (42) arranged in parallel.

10. Power semiconductor module according to one of Claims 1 to 9, **characterized in that**
- between the first main electrode (31) and the contact stamp (5) there is at least one electrically conducting layer.

11. Power semiconductor module according to one of Claims 1 to 10, **characterized in that**
- between the second main electrode (32) and the base plate (1) there is at least one electrically conducting layer.

## Revendications

1. Module semi-conducteur de puissance pouvant être mis en contact par pression, comprenant
- une plaque de base (1),
- une plaque de revêtement (2),
- au moins un élément semi-conducteur (3) avec un premier branchement principal (31) et avec un second branchement principal (32), qui est en liaison électroconductrice avec la plaque de base (1),
- au moins un élément de ressort (4), qui est disposé entre le premier branchement principal (31) et la plaque de revêtement (32),
**caractérisé en ce que**,
- une liaison électroconductrice comprenant un poinçon de contact (5) est guidée entre le premier branchement principal (31) et la plaque de revêtement (2) à travers une zone intérieure de l'élément de ressort (4), l'élément de ressort (4) servant à la transmission de force entre la plaque de revêtement (2) et le poinçon de contact (5).

2. Module semi-conducteur de puissance selon la revendication 1, **caractérisé en ce que**
- le poinçon de contact (5) présente sur un côté avant (51), tourné vers la plaque de revêtement (2), un élément de liaison (6) déformable qui est en liaison électroconductrice avec la plaque de pression (2).

3. Module semi-conducteur de puissance selon la revendication 2, **caractérisé en ce que**
- l'élément de liaison (6) est placé au moyen d'une liaison (56) fixe et à adhésion par matière sur le côté avant (51) du poinçon de contact (5).

4. Module semi-conducteur de puissance selon la revendication 2 ou 3, **caractérisé en ce que**
- une force peut être transmise par l'élément de ressort (4) entre le poinçon de contact (5) et l'élément de liaison (6).

5. Module semi-conducteur de puissance selon la revendication 4, **caractérisé en ce que**
- pour la transmission de la force entre le poinçon de contact (5) et l'élément de liaison (6), il est prévu un élément de pression (7) entre le poinçon de contact (5) et l'élément de liaison (6).

6. Module semi-conducteur de puissance selon la revendication 5, **caractérisé en ce que**
- l'élément de pression (7) est réalisé sensiblement en forme de gobelet et une collerette de poinçon (52) du poinçon de contact (5) est guidée par une ouverture (71) côté fond dans l'élément de pression (7).

7. Module semi-conducteur de puissance selon l'une quelconque des revendications précédentes, **caractérisé en ce que**
- l'élément de pression (7) est à base de matériau électro-isolant.

8. Module semi-conducteur de puissance selon l'une quelconque des revendications précédentes, **caractérisé en ce que**
- l'élément de ressort (4) est formé d'une pile de ressorts à disque.

9. Module semi-conducteur de puissance selon l'une quelconque des revendications 1 à 7, **caractérisé en ce que**
- l'élément de ressort (4) présente plusieurs ressorts individuels (42) disposés en parallèle.

10. Module semi-conducteur de puissance selon l'une quelconque des revendications 1 à 9, **caractérisé en ce que**
- au moins une couche électroconductrice se trouve entre la première électrode principale (31) et le poinçon de contact (5).

11. Module semi-conducteur de puissance selon l'une quelconque des revendications 1 à 10, **caractérisé en ce que**
- au moins une couche électroconductrice se trouve entre la seconde électrode principale (32) et la plaque de base (1).
